# EUROPEAN PATENT APPLICATION

(11) **EP 1 217 746 A1**
(43) Date of publication of application: **26.06.2002**
(21) Application number: 00830829.8
(22) Date of filing: 18.12.2000
(51) Int. Cl.: H03M 3/00

(54) **A process for compensating matching errors in analog/digital converters of cascaded structure and a corresponding converter**

(71) Applicant: STMicroelectronics S.r.l., 20041 Agrate Brianza (Milano) (IT)
(72) Inventor: Dalle Feste, Sandro, 28100 Novara (IT); Serina, Nadia, 20052 Monza (Milano) (IT); Cesura, Giovanni, 26100 Cremona (IT); Bianchessi, Marco, 20066 Melzo (Milano) (IT)
(74) Representative: Bosotti, Luciano

(57) **Abstract**

A test signal (TS) with given spectral characteristics is injected (201) at input to the quantizer stage (20) of the converter. The same test signal (TS) is subjected to cross-correlation (30) with a given signal (Y(z)) so as to generate (31) coefficients used for filtering (32) the quantization noise converted (27) into digital form. In this way, a compensation signal is obtained which is applied to the output signal of the quantizer stage (20) jointly with a first compensation signal obtained by applying, to the quantization noise converted into digital form, the same transfer function (28) of the converter. In this way a signal is obtained which, in addition to being used as the global output signal (Y(z)) of the converter, is also used for the aforesaid operation of cross-correlation with the test signal (TS).

## Description

### Field of the invention

The present invention relates to analog/digital converters and in particular relates to converters with cascaded structure.

### Description of prior art

In the development of analog/digital converters, and above all of converters based on a cascaded sigma-delta architecture, the performance obtainable in terms of signal-to-noise ratio, effective resolution, spurious free dynamic range, etc. depends to a large extent upon the matching between the various paths of the analog signals within the structure.

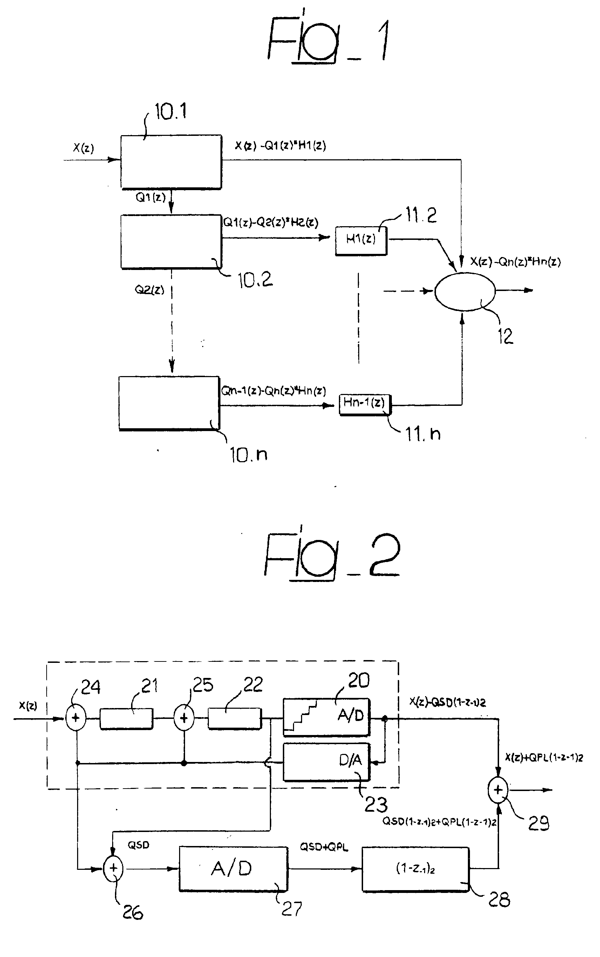

The architecture of a cascaded sigma-delta converter is presented in Figure 1, where it may be seen that the input signal (X(z)) is fed in succession to a series of modulators (quantizers) 10.1, 10.2, ..., 10.*n*. The outputs of these modulators, which are subjected to respective transfer functions 11.1 (here supposed to be unitary or as being in actual fact comprised in the modulator 10.1, 11.2, ..., 11.*n*, flow together towards an adder node 12 to generate the output signal converted into digital form.

In general, the term "cascaded" modulators is used in the case where the conversion process takes place via a coarse stage with sigma-delta architecture, and stages are added which progressively process the quantization noise as this is introduced from the previous stage and then eventually process the difference signal, which eliminates all the intermediate noise contributions, presenting at output the input signal appropriately converted, added to the noise of the last stage, the said noise being made up of the product of the transfer functions of the first *n* -1 stages.

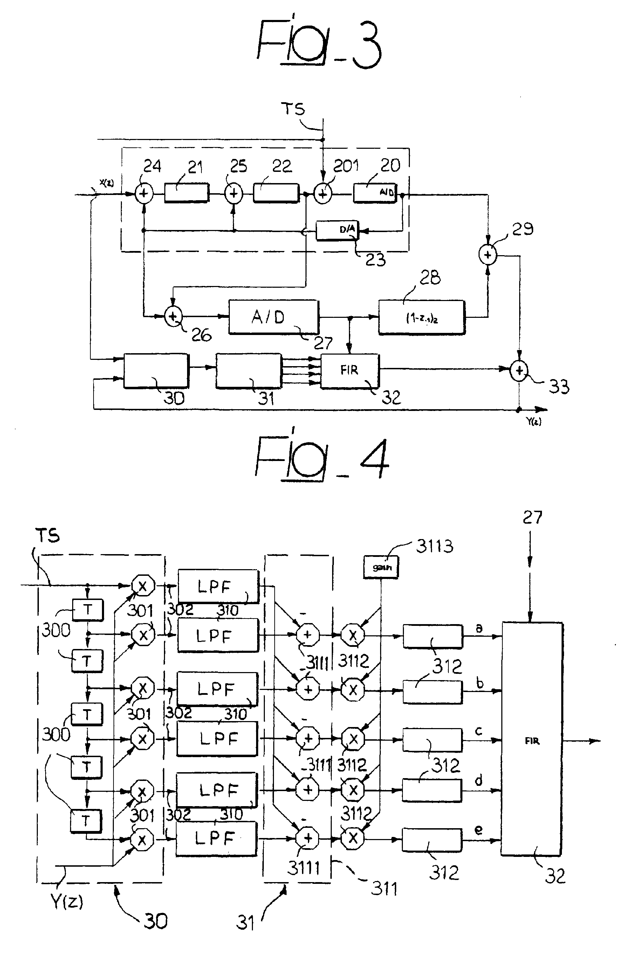

In this connection, Figure 2, which refers to the prior art as does Figure 1, relates to another type of cascaded architecture comprising a quantizer stage 20 (for example a four-bit quantizer stage) to which the input signal X(z) is supplied through two integrator stages 21, 22 cascaded together.

The quantized signal at output from stage 20 is reconverted into analog form in a D-A stage 23 and retransferred to the inputs of the integrator stages 21 and 22 at respective adder nodes 24 and 25.

The converter thus formed has a given transfer function, ideally of the type (1 - z⁻¹)².

The foregoing corresponds to criteria known to the art.

Likewise known is the fact that the input signal X(z), converted into digital form by means of the stage 20 (in the quantitative example to which reference will be made in what follows the said stage is a second-order sigma-delta modulator with four-bit quantizer operating with an oversampling factor of four) and reconverted into analog form in stage 23, is added (with sign) in a node 26 to the signal at output from the second integrator 23, namely to the input signal of the quantizer 20. In this way, at output from the node 26 an analog signal is generated which indicates the quantization noise, expressed in analog form, calculated as the difference between the signal at input to the quantizer and the signal downstream of the D-A converter.

The above-mentioned quantization-noise signal is converted into digital form via a converter 27 (which may, for example, be a nine-bit pipeline converter). The same transfer function of the sigma-delta modulator is applied to the output signal of the converter 27, in a block 28.

All the foregoing enables the signal thus obtained to be applied as a compensation signal to an output adder into which the output signal of the quantizer 20 flows. The compensation signal is in fact added (with sign) to the quantization noise, thus cancelling out the latter.

In practice the performance achievable by means of the aforementioned architecture is limited by the fact that any non-ideal conditions that may be present in the system concur in causing non-perfect cancelling-out of the quantization noise of the first stage.

The origins of the above-mentioned non-ideal conditions may be traced back to non-ideal behaviour of the operational amplifiers present in the structure (finite dc gain, finite gain-bandwidth product, finite slew rate, etc.), to the non-ideal behaviour of the switches, to the mismatch of the values of the capacitors, and to the natural process spreads.

For example, using the parameters that appear in the table below, the loss in terms of signal-to-noise ratio as compared to the ideal case may even be in the region of 25 dB. This means, in such conditions, losing in practice up to 4 bits in terms of effective resolution of the converter.

**Table**

| | |
|---|---|
| Sampling frequency | 80 MHz |
| Input amplitude | 1.2 Vpp |
| Input frequency of signal | 1 MHz |
| DC gain of operational amplifiers | 60 dB |
| Gain-bandwidth product of operational amplifiers | 400 MHz |
| Slew rate of operational amplifiers | 500 V/µsec |

### Objects and summary of the invention

The object of the present invention is to provide an efficient structure, such as to enable correction of the effects of the non-ideal conditions referred to above.

According to the present invention, the above purpose is achieved thanks to a process having the characteristics specifically called for in the claims which follow. The invention also relates to the corresponding converter.

In brief, the invention is based upon the insertion of a test signal having given spectral characteristics in the very position of generation of the quantization noise of the sigma-delta modulator, and upon the measurement of the said signal on the output signal by means of calculation of the cross-correlation function.

In this way it is possible to characterize the response to the actual pulse that the noise of the first stage undergoes in its path from the input to the output. The knowledge of this response to the pulse can be exploited for the correction itself, in particular resorting to the hardware structure that creates the pulse and to its peculiarities, which will be dealt with in what follows.

On the basis of the above premises, the main point of the invention lies in the evaluation of the mismatch value that directly influences the transfer function of the sigma-delta branch, vitiating the global result of the architecture. In order to be able to evaluate the effective function implemented by the said branch of the architecture, the tool of cross-correlation of a known test signal with the output from the converter as a whole is employed, and a correction operation is implemented which consists in compensating the transfer function of the sigma-delta noise - ideally, (1 - z⁻¹)² - through an operation on the pipeline branch, in which, instead, the function implemented is exactly (1 - z⁻¹)² because it is implemented in the digital domain.

### Detailed description of the drawings

The invention will now be described, purely by way of non-limiting example, with reference to the attached drawings, in which:
- Figures 1 and 2, which relate to the prior art, have already been described previously;
- Figure 3 illustrates the application of the invention in the framework of a scheme substantially corresponding to the scheme of Figure 2;
- Figure 4 illustrates, in a detailed way, the criteria of construction of some of the elements represented in Figure 3;
- Figure 5 is, in turn, a detailed representation of the criteria of construction of some of the elements represented in Figure 4; and
- Figure 6 is a diagram illustrating the results that may be obtained using the invention.

As has been said, the scheme of Figure 3 corresponds, in its basic features, to the scheme of Figure 2. For this reason, parts and elements (as well as their functions) that have already been described previously with reference to Figure 2 will not be described again in reference to Figure 3.

In particular, parts and elements already described previously are indicated, in Figure 3, with the same reference numbers as those used in Figure 2.

The architecture that is able to implement the general criterion of operation described previously envisages (see in this connection the scheme of Figure 3) that a test signal TS should be injected both at input to the quantizer stage 20 (at an adder node 201) and to the input of a cross-correlator stage 30.

Cascaded to the stage 30 is a coefficient-synthesis stage 31 which is in turn followed by a finite-impulse-response (FIR) filter 32 operating on the output signal of the converter 27.

The signal resulting from the filtering action of the FIR filter 32 (which operates with the coefficients synthesized by the stage 31) is applied to an adder node 33, to which also the output signal of the adder node 29 flows.

In addition to constituting the global output signal Y(z) of the converter, the output signal of the node 33 is used as additional input signal of the cross-correlator 30 so as to undergo cross-correlation with the test signal TS.

The test signal TS is cross-correlated with the global output Y(z) of the converter, using a correlation window of five samples generated by getting the signal TS to pass through a corresponding number of delay elements 300, each of which applies, to the signal TS, a delay of the amount T equal to the period of the clock that regulates operation of the converter (factor z⁻¹ in the domain of the transform z).

Both the "original" version of the test signal TS and the various delayed versions (numbering five in the examplary embodiment illustrated herein) generated by means of the delay elements 300 undergo multiplication with the output signal Y(z) in corresponding multiplication nodes 301.

The above operation thus makes it possible to estimate in the first place the transfer function that the test signal TS undergoes from its introduction into the sigma-delta modulator up to output, which is a function that corresponds to a finite impulse response.

The above statement will appear clear if the following explanation is given: the test signal TS is injected into the modulator together with the quantization error and is then filtered with the same transfer function. This function should be (1 - z⁻¹)², but, since it is performed in the analog domain it is found to be inexact, and hence the actual function has components also in z⁻³, z⁻⁴, etc.

As does the noise of the sigma-delta modulator, also the test signal TS passes into the pipeline branch (converter 27) to be converted and filtered with the digital function (1 - z⁻¹)² implemented by the block 28.

This means that when the compensation difference between the two branches is made (in the node 29), it is not possible to have a perfect cancelling-out in so far as there remains a residue which has a transfer function of the type a + bz⁻¹ + cz⁻² + dz⁻³ + ez⁻⁴, etc.

The purpose of the cross-correlator implemented is therefore to evaluate the above coefficients a, b, c, d, and e.

The test signal TS is preferably chosen at two levels in order to avoid the use of a D-A converter when the test signal TS is inserted in the loop of the modulator, and, in this way, the multiplications are reduced to simple XOR operations. The spectral characteristics of the signal must guarantee the absence of correlation with the noise introduced by the quantizer of the sigma-delta converter and with the input signal.

The signal in question may be readily generated within the system using a digital circuit based upon a fedback chain of n flip-flops. In this way, the signal obtained has a periodicity of 2^{*n*} -1 clock pulses.

The various outputs of the cross-correlation function, i.e., the outputs of the multipliers 301, present on respective lines 302, are low-pass filtered in respective low-pass filters 310, each one of which having the structure represented in the scheme of Figure 5. In the scheme shown in Figure 5 (a scheme the operating criteria of which will not be described in detail herein in so far as they are evident from the graphical representation), the numbers 3101 and 3102 designate respective adder and subtracter nodes, whilst the references 3103 indicate delay lines which delay the signal applied to their inputs by an interval T equal to the clock period of circuit operation.

The blocks designated by 3104 are gain blocks, whereas the block 3105 represents a module of decimation by a factor equal to the periodicity of the test signal TS. In the case where the latter signal is generated as described previously and resorting to a generator made up of nine flip-flops, a decimation factor of 511 is used. The two blocks designated by 3106 are, instead, blocks that perform truncation at a given number of bits of the signal brought to their inputs.

The need to filter out the high-frequency components derives from the fact that the aim is to take into account only the low-frequency variations of the input signal to the cross-correlator 30, excluding the high-frequency components which could lead to difficulty in convergence of the algorithm.

Basically, the structure appearing in the diagram of Figure 5 corresponds to a first-order sinc filter cascaded to a first-order infinite-impulse-response (IIR) filter.

As has already been said, the signal is decimated by a factor of, for instance, 511. In the structure, noise-shaping techniques for shaping the truncation noise are preferably used so as to reduce to a minimum (for instance, to a value of 16 bits) the number of bits necessary for representing the samples inside the filter itself.

The values obtained at output from the correlators may at times be subject to offset. This offset is due to the non-complete de-correlation that might exist between the test signal TS and the input signal, which means that part of the useful signal may be interpreted as a test signal.

The presence of the offset worsens the performance of the corrector in that it limits the precision with which the coefficients are estimated.

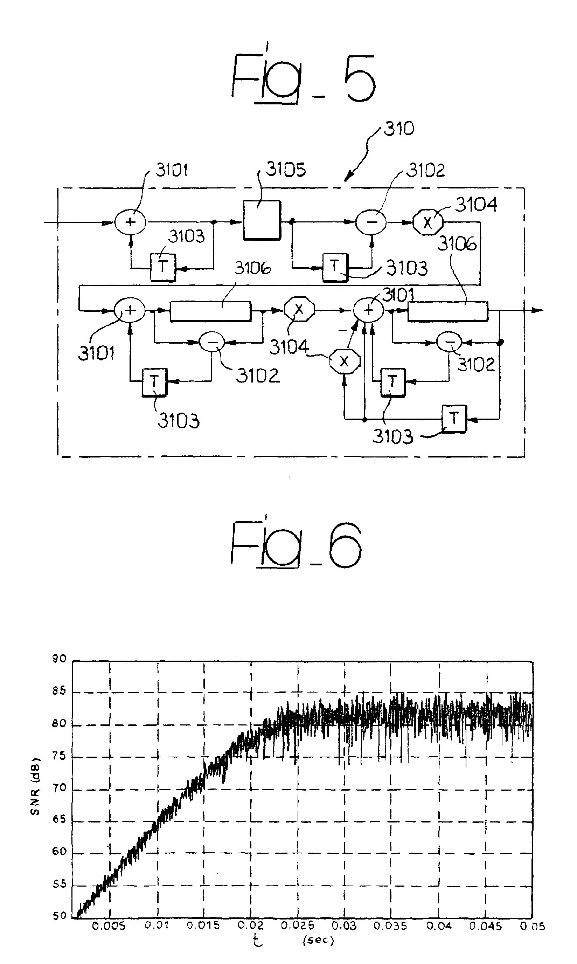

In order to eliminate the offset, in the scheme represented in Figure 4 a further correlator 311 has been inserted in addition to the ones (numbering five) used to evaluate the coefficients.

The correlator or interpolator 311 is made to work with the test signal and a copy of the output signal retarded by a sampling instant, with the result that a correlation in T = -1 is obtained. It will be appreciated that this result is obtained by causing to flow towards respective adder nodes 3111 a respective pair of values obtained at output from the correlators (at output from corresponding low-pass filters 310) staggered by a time interval equal to T (of course, at the nodes 3111 the aforementioned addition is made with the sign, applying a negative sign to the "less delayed" value).

If the input and test signals were altogether uncorrelated, the correlator in question ought always to have a zero output, since there can exist no physical mechanism that is able to transfer the test signal at output with a delay of -1, i.e., ahead of its own entry.

If the value at output from the correlator is not zero, this is due to the correlation between the test signal TS and the input signal, and therefore represents a good estimate of the offset.

The above value is linked to the statistical and spectral characteristics of the two signals, which vary slowly. Consequently, no great error is committed in considering the offset value obtained valid also for the immediately ensuing instants. Hence, it is possible to compensate the five coefficients by subtracting this value from them.

As may be understood from both Figure 3 and Figure 4, the structure described constitutes a sort of loop, which, thanks to its convergence, enables cancellation of the test signal TS on the output, with obvious cancellation also of the noise of the first stage, which is responsible for the loss of performance.

A gain entered downstream of the filters 310 (and preferably downstream of the interpolator 311) makes it possible to keep under control both the stability of the loop and the rate of convergence.

In fact, gains that are too low slow down convergence but guarantee precision. On the other hand, high gains make it possible to reach convergence in a short time but may cause oscillation of the coefficients calculated around their optimal values.

The aforementioned action of gain control is achieved using variable-gain elements 3112, the gain values of which are regulated selectively by a gain-control unit 3113.

Finally, the reference numbers 312 designate integrator blocks that receive the signals at output from the interpolator 311 after these signals have undergone the action of gain control.

As has been said previously, the correlators yield an indication on the presence of the test signal at output from the converter.

For operation of the system, however, in the case of perfect matching of the two paths, the residue of the test signal TS at output must be zero.

Should a coefficient of the FIR filter 32 fail to be at the exact value for equalizing the paths, the corresponding correlator will detect the presence of an output signal.

Furthermore, if the coefficient in question is higher than its optimal value, the FIR filter will eliminate too much of the signal, thus overcompensating the output. This means that the residue of the output signal is of opposite sign with respect to the input, and hence the value supplied by the correlator is negative.

It is possible to arrive at the optimal values of the coefficients of the FIR filter with an iterative procedure, starting from any initial set of values, for example from five zero values, and making continuous adaptations proportional to the result of the correlation. This result may be achieved very simply precisely by using the bank of integrators 312, one per coefficient, which, continuously summing the residues calculated by the correlators, converge to the exact value of the FIR filter 32.

In this way, at output from the integrators 312 the coefficients of the filter applied by the converter to the residual noise are obtained, the said filter being designed to be applied to the signal detected by the branch of the pipeline converter 27 for compensating the difference between the two branches; in this way, a filter of the FIR type is obtained.

The coefficients are preferably updated at a rate 511 times lower than the sampling frequency of the signal.

Figure 6 is a diagram illustrating the efficacy of operation of the structure described previously.

Figure 6 shows the plot of the signal-to-noise ratio (on the ordinate) as a function of time t, expressed in seconds.

The diagram of Figure 6 shows that it is possible to correct the mismatch analyzed until a performance verging on the ideal performance is achieved. The effective resolution and the rate of convergence are functions of the precision adopted and of the loop gain, and must be sized in accordance with the requisites that it is desired to meet. This fact renders the invention of a general nature and applicable also to other contexts.

Of course, without prejudice to the principle of the invention, the details of construction and the embodiments may vary widely with respect to what is described and illustrated herein, without thereby departing from the scope of the present invention as defined in the ensuing claims.

## Claims

1. A process for compensating matching errors in cascaded-structure analog/digital converters having a given transfer function and comprising a quantizer stage (20) operating on a respective input signal for generating a respective output signal, the said process comprising the operations of:
- determining (26) the quantization noise of said quantizer stage (20) in analog form as the difference between the respective input and output signals;
- converting (27) said quantization noise into digital form;
- applying (28) to said quantization noise converted into digital form said given transfer function so as to obtain a compensation signal; and
- applying (29) said compensation signal to said respective output signal of the quantizer stage,
**characterized in that** it comprises the operations of:
- injecting a test signal (TS) at input to said quantizer stage (20);
- subjecting said test signal (TS) to cross-correlation with a given signal (Y(z)) so as to generate at least one cross-correlation signal (302) ;
- processing (32) said quantization noise converted into digital form according to said cross-correlation signal so as to obtain a further compensation signal;
- applying said further compensation signal, jointly with said compensation signal, to said respective output signal of the quantizer stage so as to obtain a global output signal (Y(z)) of the converter; and
- using, as said given signal for cross-correlation with said test signal (TS), said global output signal (Y(z)) of the converter.

2. The process according to Claim 1, **characterized in that** said test signal (TS) is chosen with spectral characteristics such as to be uncorrelated with respect to said quantization noise and said respective input signal.

3. The process according to Claim 1 or Claim 2, **characterized in that** said test signal (TS) is chosen as a two-level signal.

4. The process according to Claim 3, **characterized in that** it comprises the operation of generating said test signal (TS) by means of a flip-flop fedback chain, whereby said test signal has a periodicity of 2^{*n*} - 1 clock pulses, where n indicates the number of said flip-flops.

5. The process according to any one of the preceding claims, **characterized in that** it comprises the operation of subjecting said cross-correlation signal to low-pass filtering with decimation (310).

6. The process according to Claim 5, **characterized in that** said low-pass filtering operation comprises, cascaded together, a sinc filtering stage, a decimation stage and an IIR filtering stage, the latter two stages being preferably both of the first order.

7. The process according to Claim 4 and either one of Claims 5 and 6, **characterized in that** said decimation is carried out with a factor equal to the periodicity of said test signal.

8. The process according to any one of the preceding claims, **characterized in that** it comprises the operation of subjecting said cross-correlation signal to a further offset-compensation operation (311).

9. The process according to Claim 8, **characterized in that** said further offset-compensation operation is obtained by summing with opposite sign (3111) versions of said cross-correlation signal at time -1, the said versions having been obtained by delaying the output signal (Y(z)) with respect to said test signal (TS).

10. The process according to Claim 5 and Claim 8, **characterized in that** said further offset-compensation operation is carried out after said low-pass filtering.

11. The process according to any one of the preceding claims, **characterized in that** it comprises the operation of selectively controlling (3112, 3113) the gain to which said cross-correlation signal is subjected.

12. The process according to any one of the preceding claims, **characterized in that** it comprises the operation of subjecting said cross-correlation signal to integration (312).

13. The process according to Claim 5 and Claim 12, **characterized in that** said integration operation (312) is performed after said low-pass filtering.

14. The process according to Claim 8 and Claim 12, **characterized in that** said integration operation (312) is performed after said further offset-compensation operation.

15. The process according to any one of the preceding claims, **characterized in that** said cross-correlation signal is used for generating a set of coefficients preferably obtained starting from versions staggered in time (300) of said test signal (TS) and from said global output signal (Y(z)) of the converter.

16. The process according to Claim 1, **characterized in that** said further compensation signal is obtained by subjecting said quantization noise converted into digital form to a filtering operation (32) according to said set of coefficients.

17. The process according to Claim 16, **characterized in that** said filtering operation is a finite-impulse-response (FIR) filtering operation.

18. The process according to Claim 15 and either one of Claims 16 and 17, **characterized in that** said filtering operation (32) is carried out according to the coefficients of said set.

19. A cascaded-structure analog/digital converter with given transfer function and comprising a quantizer stage (20) operating on a respective input signal for generating a respective output signal, the said converter comprising:
- a noise-determination circuit (23, 26) for determining the quantization noise of said quantizer stage (20) in analog form as the difference between the respective input and output signals;
- a converter circuit (27) for converting said quantization noise into digital form;
- a module (26) for applying to said quantization noise converted into digital form said given transfer function so as to obtain a compensation signal to be applied (29) to said respective output signal of the quantizer stage (20),
**characterized in that** it comprises:
- an input (201) for injecting a test signal (TS) at input to said quantizer stage (20);
- a cross-correlator (30) for subjecting said test signal (TS) to cross-correlation with a given signal (Y(z)) so as to generate (31) a cross-correlation signal (302) ;
- a processing circuit (31, 32) for processing said quantization signal converted into digital form according to said cross-correlation signal in order to obtain a further compensation signal; and
- a compensation circuit (29, 33) for applying said further compensation signal, jointly with said compensation signal, to said respective output signal of the quantizer stage so as to obtain a global output signal (Y(z)) of the converter;
and **in that** said cross-correlator uses, as said given signal for cross-correlation with said test signal (TS), said global output signal (Y(z)) of the converter.

20. The converter according to Claim 19, **characterized in that** said input (201) is configured for receiving said test signal (TS) as a two-level signal.

21. The converter according to Claim 19 or Claim 20, **characterized in that** it comprises a flip-flop fedback chain for generating said test signal (TS) with a periodicity of 2^{*n*} - 1 clock pulses, where n indicates the number of said flip-flops.

22. The converter according to any one of Claims 19 to 21, **characterized in that** it comprises at least one low-pass filtering circuit (310) for subjecting said cross-correlation signal to low-pass filtering.

23. The converter according to Claim 22, **characterized in that** said at least one low-pass filtering circuit (310) comprises, cascaded together, a sinc filter and an IIR filter, preferably both of the first order.

24. The converter according to Claim 22 or Claim 23, **characterized in that** said at least one low-pass filter (310) performs a function of decimation (3105) of the processed signal.

25. The converter according to Claim 21 and Claim 24, **characterized in that** said decimation is performed with a factor equal to the periodicity of said test signal.

26. The converter according to any one of Claims 19 to 25, **characterized in that** said cross-correlator (30) has, cascaded thereto, a further correlator/interpolator (311) for performing a further correlation on said cross-correlation signal.

27. The converter according to Claim 26, **characterized in that** said further correlator/interpolator (311) comprises a set of adder with sign nodes (311) operating on respective versions staggered in time of said cross-correlation signal.

28. The converter according to Claim 22 and Claim 26, **characterized in that** said further correlator/interpolator (311) is set downstream of said at least one low-pass circuit (310).

29. The converter according to any one of Claims 19 to 28, **characterized in that** it comprises at least one variable-gain element (3112) for selectively varying the gain to which said cross-correlation signal is subjected.

30. The converter according to any one of Claims 19 to 29, **characterized in that** it comprises at least one integrator (312) operating on said cross-correlation signal.

31. The converter according to Claim 22 and Claim 30, **characterized in that** said at least one integrator (312) is located downstream of said at least one low-pass filtering circuit (310).

32. The converter according to Claim 26 and Claim 30, **characterized in that** said integrator (312) is located downstream of said further correlator/interpolator (311).

33. The converter according to any one of Claims 19 to 32, **characterized in that** said cross-correlator (30) generates said cross-correlation signal in the form of a set of coefficients (302) preferably obtained starting from versions staggered in time (300) of said test signal (TS) and from said global output signal (Y(z)) of the converter.

34. The converter according to any of Claims 19 to 33, **characterized in that** said processing circuit comprises a filter (32) acting on said quantization noise converted into digital form according to said cross-correlation signal.

35. The converter according to Claim 34, **characterized in that** said filter (32) is a finite-impulse-response (FIR) filter.

36. The converter according to Claim 33 and either one of Claims 34 and 35, **characterized in that** said filter (32) operates on the basis of the coefficients of said set.
